# EUROPEAN PATENT APPLICATION

(11) **EP 2 680 019 A1**
(43) Date of publication of application: **01.01.2014**
(21) Application number: 12749874.9
(22) Date of filing: 21.02.2012
(51) Int. Cl.: G01R 31/34, G05F 1/00

(54) **DEVICE THAT GENERATES ELECTRICAL DISTURBANCES**

(30) Priority: 24.02.2011 ES 201130242
(71) Applicant: For Optimal Renewable Energy Systems, S.L, 50197 Zaragoza (ES)
(72) Inventor: GARCIA GRACIA, Miguel, E-50197 Zaragoza (ES); MARTINEZ GUILLEN, Miguel Angel, E-50197 Zaragoza (ES); LÓPEZ ANDÍA, Diego, E-50197 Zaragoza (ES); MARTÍN ARROYO, Susana, E-50197 Zaragoza (ES); LARREN ARCONADA, Aitor, E-50197 Zaragoza (ES); COMECH MORENO, Maria Paz, E-50197 Zaragoza (ES); ALONSO HERRANZ, Adrián David, E-50197 Zaragoza (ES); ALONSO SÁDABA, Oscar, E-50197 Zaragoza (ES); COVA ACOSTA, Miguel Angel, E-50197 Zaragoza (ES); EL HALABI FARES, Nabil, E-50197 Zaragoza (ES); VILLÉN MARTÍNEZ, Maria Teresa, E-50197 Zaragoza (ES); BORROY VICENTE, Samuel, E-50197 Zaragoza (ES); GIMENEZ DE URTASUN, Laura, E-50197 Zaragoza (ES)
(74) Representative: Schäfer, Matthias W.
(86) International application number: PCT/ES2012/070092
(87) International publication number: WO 2012/113951

(57) **Abstract**

Device generating electrical disturbances in the grid connected to a system for generating electrical energy, such as a wind turbine or a solar plant, in order to test the response of generators to disturbances in the grid, disturbances being understood as voltage dips, voltage surges, phase jumps and frequency changes, which comprises a three-phase transformer or three single-phase transformers having variable taps connected in series between the collector system and the generator, said transformer being responsible for producing voltage surges, voltage dips and phase jumps by means of the switching of a bypass branch with an impedance with the branch that contains the transformer, there likewise being a battery of capacitors arranged in parallel for producing voltage surges with the aid of series impedance and/or resistance. In addition, there is a reducer transformer arranged in parallel, which is connected to a rectifier, and the latter is connected to resistances for testing the response to frequency variations.

## Description

This document relates, as its title indicates, to a device generating electrical disturbances in the grid connected to a system for generating electrical energy, such as a wind turbine or a solar plant, in order to test the response of generators to disturbances in the grid, disturbances being understood as voltage dips, voltage surges, phase jumps and frequency changes.

### SCOPE OF THE INVENTION

The invention presented herein describes a device generating disturbances (disturbances being understood as voltage dips of a depth of up to 100%, voltage surges of up to 173% and phase jumps of up to 35°) for its connection to a system for generating electrical energy, more specifically between the feeder line and the system for generating electrical energy, such as a wind turbine.

### BACKGROUND TO THE INVENTION

There are many well-known and varied types of devices for generating disturbances such as voltage dips, voltage surges, frequency variations and phase jumps in electrical generator machines:
Article *"*Voltage Sag and Swell Generator with Series Injected Inverter for the KCPP"; YH Chung, GH Kwon, TB Park, HJ Kim and YS Jeon. 2004 International Conference on Power System Technology-Powercon 2004 Singapore. This article describes a device for generating voltage dips, voltage surges and phase jumps in electricity-generating systems of up to 4 MW. The device described in this article is based on power electronics and is formed by a series-connected inverter, a dc bus capacitor for energy storage, and a rectifier. In this device the magnitude and phase of the input voltages is modified by the switching of the power devices (IGBTs, IGCTs, etc).

Patent US 7218122 *"Power disturbance generator"* describes a device generating voltage dips and voltage surges in loads and automated process equipment in an industrial environment. This device can be used to perform only three types of tests by varying the voltage from one phase to another.

Patent WO 2005069470 (US 20080231252) *"Sag-Swell and outage generator for performance test of custom power devices"* describes a device used to test low-power and low-voltage devices in response to voltage surges and undervoltage. It is not applicable, therefore, to systems for generating electricity with voltage levels in excess of 500 V and power levels of over 100 kW.

Patent US 6285169 *"Sag generator with switch-mode impedance"* is a device that generates voltage dips and consists of an IGBT bridge, in which the magnitude of the input voltage is modified by varying their duty cycle. It is viable only at low power levels and its use and object is based on it being portable and lightweight. It is not applicable to the generation of electrical energy (wind turbines, etc).

Patent WO0060430 (US 5920132) *"Non-Rotating portable sag generator"* is based on the connection of six auto-transformers with variable taps (two per phase). This patent applies to performing voltage-dip tests in factories with voltages below 500 V. Because of the technology it uses it cannot be applied to high-power electricity-generating systems with a medium-voltage connection.

Patent US 5886429 *"Voltage sag*/*swell testing station"* describes a device used in an industrial environment to test electronic equipment connected at a low voltage in response to voltage dips and voltage surges, and never to test equipment with a medium-voltage connection.

Patent US 20030230937 *"sag generator with plurality of switch technologies"* is a test device for testing devices with a low-voltage connection in response to undervoltage. This device uses different switching elements based on power electronics, such as IGBT bridges.

Patent WO 2006106163 (US 20090066166) *"Low-Voltage dips generator device"* refers to a voltage-dip generator for testing electrical power generators using an inductive divider and including impedances in series to reduce disturbances in the grid. This device can only be connected at a low voltage.

Patent WO2006108890 (US 20090212748) *"Voltage sag generator device"* describes a voltage sag generator device that uses three parallel power transformers without variable taps in order to vary the impedance of the short-circuit branch. It is designed for the purpose of checking the behaviour of electrical generator machines such as wind turbines in response to voltage dips. Voltage dips are only achieved at three depth levels: 50, 66 and 75%.

Article *"*Fault Ride Through Test based on Transformer Switching", authors: Rainer Klosse, Fritz Santjer, presented at the Eighth International Workshop on Large-Scale Integration of Wind Power into Power Systems as well as on Transmission Networks for Offshore Wind Farms, October 2009, Bremen (Germany). This article is based on the use of an auto-transformer connected in series between the grid and the device to be tested in order to produce voltage surges of up to 1.5 p.u and voltage dips in the 0.0-1.0 p.u range. It also allows phase jumps to be produced. The phase jumps produced according to this layout require the production of voltage dips, as dictated by the auto-transformer triangle configuration. The layout proposed in this article uses power electronics for the connection of the auto-transformer and for the connection of the bypass, as a result of which this layout is much more expensive than using electromechanical switches.

Patent US 20040101079 *"Delay-lock-loop with improved accuracy and range"* refers to a device that generates delayed and/or phase-shifted (normally square) clock signals, these signals being control signals and never power signals.

Patent US 5099202 *"Phase shift generator"* describes a device that receives two input pulses and generates two phase-shifted output pulses. It is not applicable to the grid or to high levels of power or high voltages.

Patent WO 0176058 *"Universal frequency electrical generator"* describes an energy converter that allows the speed of the rotor shaft or the output frequency to be varied separately. Its scope of application are electrical machines such as generators, though its function is to deliver the power generated by the generator at the grid frequency (50 or 60 Hz) both during disturbances and during continuous operating conditions. In other words it is not designed to generate frequency variations. Furthermore, it is only applicable to low-voltage systems.

Patent WO 2005046048 *"Frequency generator"* describes a device for obtaining a high-frequency square signal from a low-frequency signal. This device generates low-power clock signals.

Patent WO 2005099063 *"Method for operating a frequency converter of a generator and wind energy turbine having a generator operated according to the method"* refers to a method for operating a converter connected to an energy generator such as a wind turbine during voltage dips or in normal operating conditions in order to regulate the converter.

Patent US 6185264 *"Apparatus and method for frequency shift keying"* is a device used in the transmission of data on a carrier wave. This signal is introduced at a specific frequency.

Patent ES 2308918 *"Device generating voltage dips"* presents a device designed for field testing between electrical generators and the collector device, but which is capable only of producing voltage dips, it being unable to test other types of electrical disturbances, which means that only a partial test is possible.

### DESCRIPTION OF THE INVENTION

In order to solve existing problems in the simulation or testing of electrical disturbances in electricity-generating facilities, the device generating electrical disturbances that is the object of this invention has been designed and which comprises a three-phase transformer or three single-phase transformers having variable taps connected in series between the collector system and the generator, this transformer being required to produce voltage surges, voltage dips and phase jumps, by means of the switching of a bypass branch with an impedance with the branch containing the transformer, it also being arranged in parallel with a battery of capacitors for producing voltage surges with the aid of a series impedance and/or resistance. It is also arranged in parallel with a step-down transformer connected to a rectifier, which is itself connected to resistances for testing frequency variations.

This device is preferably mounted on a truck bed and/or container so that it may be transported easily, as it has to be taken to different power plants. The power limit of the device to be tested is 10 MW, though this may be increased by resizing the equipment it is comprised of (the transformer, impedances, rectifier, etc). The layout comprises a variable tap three-phase transformer or three parallel single-phase transformers with impedances (resistors and/or inductors) for limiting the current while the transformer is short-circuited. This transformer has variable taps, which allows it to perform voltage-dip and/or voltage-surge tests at different voltage levels. It is also provided with, parallel-connected with the device to be tested, a battery of capacitors, that enables voltage surges and phase jumps to be produced.

In order to carry out frequency tests it is provided with a parallel-connected step-down transformer connected to a rectifier and to resistances. The principle of the frequency test involves leaving the device to be tested in island operation, in other words disconnected from the grid, and demand the required power in order to increase/decrease the frequency.

The scope of application of this device is the testing of high-and low-power generators connected at medium or low voltage in response to grid disturbances.

The device generating electrical disturbances that is presented herein offers numerous advantages in comparison to the systems currently available, the most important of them being the fact that it is completely versatile, allowing electrical power generators to be tested in response to voltage dips, voltage surges, frequency variations and phase jumps.

Another added advantage is that in carrying out voltage-surge, phase-shifting and undervoltage tests it uses electromechanical vacuum switches, which are quicker than the conventional SF6s used, thereby limiting the amount of time for which the transformer is subjected to surge currents and also making the device cheaper than it would be if it used electronic switches.

Another advantage of this device is that the phase-shifting test does not require the production of a voltage dip.

It is important to point out another advantage resulting from the non-use of power electronics as this makes the device more reliable in response to faults, as electronic devices are highly susceptible to faults at the high voltages and power levels occurring during testing.

Finally, we should not overlook the undoubted advantage offered by the fact that the device can be mounted on a truck, making it a very mobile solution for field testing.

### DETAILED DESCRIPTION OF AN EMBODIMENT OF THE INVENTION

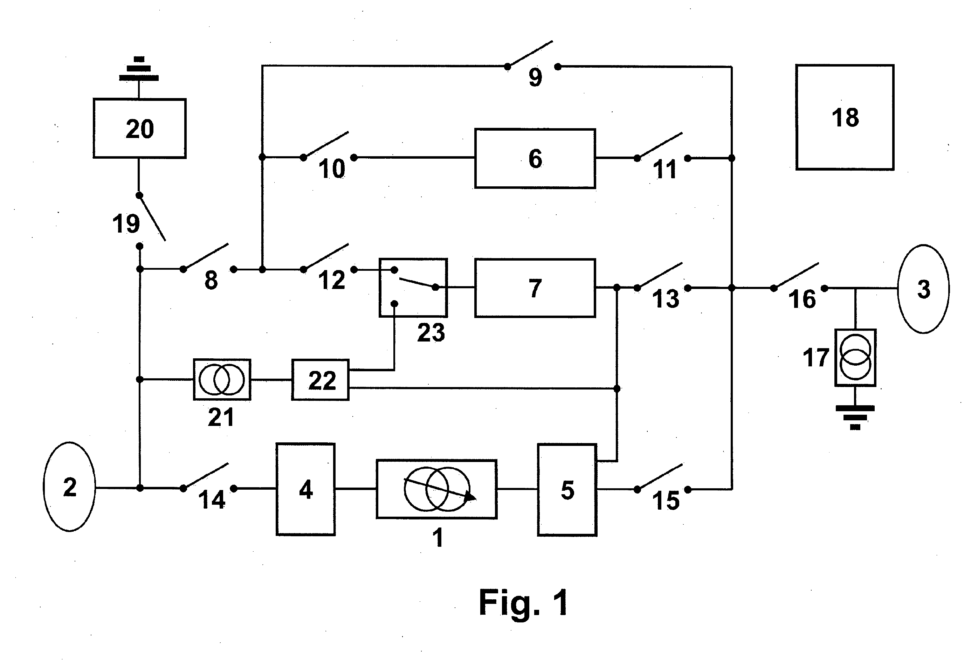

To provide a better understanding of the object of the present invention, a preferred practical embodiment of said device generating electrical disturbances is shown in the drawings attached. In said drawings Figure 1 shows a simplified single-line block diagram.

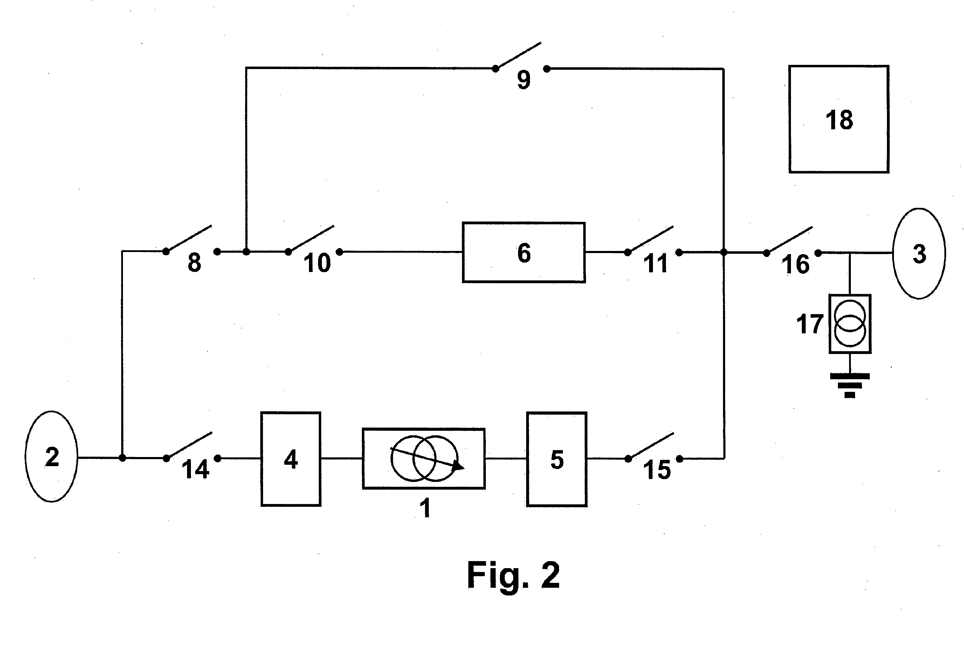

Figure 2 shows a simplified single-line block diagram of a simplified alternative embodiment.

The device generating electrical disturbances that is the object of this invention essentially comprises, as can be seen in the drawings attached, the following elements:
- a three-phase transformer (1) having variable taps connected in series between the system (2) generating electrical energy and the grid (3) connected to two connection boxes (4,5) that allow the device to produce different types of connections and also to connect the necessary phases.
- a three-phase bank of impedances (6) with different taps,
- a three-phase bank of resistances (7) with different taps,
- a step-down transformer (21) and a rectifier (22) arranged in parallel between the generator system (2) and the grid (3), and in series with the resistances (7),
- single-phase vacuum switches (8) arranged in series with the bank of impedances (6) and the bank of resistances (7) for their connection either separately or collectively with the transformer (1) and also in series between the generator system (2) and the grid (3),
- a bypass switch (9) on the three-phase bank of impedances for the direct connection of the grid (3) with the generator system (2),
- isolator switches (10) and (11) on the three-phase bank of impedances (6) for operating the impedance taps in a safe manner,
- an automatic switch (12) and an isolator switch (13) on the three-phase bank of resistances (7) used to operate the resistance taps in a safe manner,
- a connection box (23) between the resistances (7), the rectifier (22) and the automatic switch (12),
- automatic connection switches (14) and (15) switches of the transformer (1) for operating the transformer taps in a safe manner and for conducting the different types of tests,
- a coupling/decoupling circuit breaker (16) situated at the test device's outlet to the grid (3),
- an auxiliary service transformer (17) and
- the relevant control, measuring and communication devices (18), powered from the auxiliary service transformer (17),
- a battery of capacitors (20) at the input to the generator system (2),
- the connection switch (19) on said battery of capacitors (20).

The connection box (4) connecting the transformer (1) to the generator system (2) and the connection box (5) connecting the transformer (1) to the collector system (3) allow the connection of one, two or three phases for carrying out single-phase, two-phase or three-phase tests, and their inverse connection.

The device also boasts protective features that switch off the transformer in response to an internal fault in the windings of the transformer (1).

The device generating disturbances allows three-phase, two-phase and single-phase disturbances with the required voltage and duration to be generated, such as voltage dips of a depth of up to 100%, voltage surges of up to 173%, phase jumps of up to 35° and frequency variations. All these tests may vary in duration from 50 minutes and upwards and it allows tests to be reproduced at voltage levels from 500 V, with a direct connection being made to the terminals of the electricity-generating system.

Loaded on a mobile unit, such as a truck or a trailer, it allows direct testing at the location where the generator is operating without disturbing the normal operation of the other devices that make up the facility. It may be connected directly to energy-generating systems with a generating voltage in excess of 500 V and with power ratings of over 100 kW.

This device generating disturbances is characterised by a typical test procedure involving different combinations of the connections of the transformer (1) in the boxes (4) and (5), along with different connections of the banks of impedances (6) and resistances (7) involving different positions of the different switches.

To carry out voltage-surge and voltage-dip tests by means of the transformer (1) connected in series between the grid (3) and the generator (2), in a first step the switches (10) and (11) or (12) and (13) are opened and earthed, depending on whether the tests are performed with pre-insertion impedances (6) or pre-insertion resistances (7) respectively, and the required resistance (7) tap and/or impedance (6) tap is selected. Then in a second step the switches (14) and (15) are opened and earthed so that the transformer tap can be selected and the connection boxes (4) and (5) operated in a safe manner. In a third step one, two or three phases of the connection boxes (4) and (5) are connected depending on whether the test is single-phase, two-phase or three-phase, and the transformer (1) tap in the box (5) is selected as required so that the required voltage may be obtained. Then in a fourth step the switches (10) and (11) or (12) and (13) are opened, and the bypass switch of the bank of impedances (9) is opened to reduce the short-circuit current running through the transformer (1). Then, to perform the test, in a fifth step the connection switches (14) and (15) of the transformer are closed before, finally, in a sixth step the corresponding phases of the switch (8) are opened depending on whether the test is single-phase, two-phase or three-phase.

The 30-degree phase-jump test is carried out in the same manner as the voltage-surge tests, with the exception that in this case the transformer (1) is star-delta connected.

Phase-jump tests with a phase jump of other than 30 degrees are performed with the transformer (1) connected in series between the grid (3) and the generator (2), with, in a first step the transformer (1) being star-delta-connected so that in a second step the impedance (6) tap and/or resistance (7) tap may be selected in order to obtain the required phase-shift, followed by a third step in which the switches (10) and (11) or (12) and (13) are closed. Then in a fourth step the bypass switch (9) of the bank of impedances is opened, and finally, in order to perform the test in a fifth step the transformer connection switches (14) and (15) are closed.

To produce voltage surges using the battery of capacitors (20), in a first step the impedance (6) tap required to limit the short-circuit power at the test point is selected. This means that with a smaller capacity (ohmic value) the voltage can be raised when the connection switch (19) of the battery of capacitors is connected. Then, in a second step the impedance bypass switch (9) is opened, and in a third step the switch (19) on the battery of capacitors is closed.

To produce voltage dips with resistances by means of the inductive divider method, in a first step the value of the resistance (7) is selected in order to obtain the required dip depth and the impedance (6) tap necessary in order to limit the short-circuit current and isolate the test from the grid. Then, in a second step the connection box (5) is disconnected both from the transformer (1) and the switch (15) and the phases in which the voltage dip is to be produced are short-circuited, followed by a third step that involves the connection in the connection box (23) between the resistances (7) and the switch (12). Then, in a fourth step the bypass switch (9) of the bank of impedances (6) is opened in order to connect them, before a final step in which the test is performed by closing the switch (12).

The zero-residual-voltage test is carried out in the same manner as in the case of voltage dips with resistances (7), but involves disconnecting in the connection box (23) the connection between the switch (12) and the bank of resistances (7) and short-circuiting the phases in which the voltage dip is to be produced.

The test of voltage dips of low depth and long duration may be performed by connecting in series the transformer (1) and the bank of resistances (7), and these in parallel between the grid (3) and the generator (2). This involves, in a first step, selecting the impedance (6) tap in order to limit the short-circuit current, and the resistance (7) tap and the transformer (1) tap in order to adjust the residual voltage. Then, in a second step, in the connection box (4), the phases in which the dip is to be produced are connected, and, in the connection box (5), the transformer (1) is connected to the branch of the resistances (7) and, only the phases in which the fault is to be produced. In the connection box (23), the bank of resistances is disconnected from the switch (12) and from the rectifier (fault) and the branches where the voltage dip is to be produced are short-circuited in order to produce single-phase, two-phase and three-phase dips. Then, in a third step the switches (14), (12), (13) and (15) are opened prior to a fourth step in which the bypass switch (9) of the bank of impedances is opened in order to connect the impedances (6) and thereby isolate the grid from the voltage dip, before ending with a fifth step in which the switch (14) is closed in order to produce the voltage dip.

The voltage-dip test may also be performed by connecting only the transformer (1) in parallel between the grid (3) and the generator (2). This involves, in a first step, selecting the impedance (6) tap in order to limit the short-circuit current, and the transformer (1) tap in order to adjust the residual voltage. Then, in a second step in the connection box (4) the phases in which the dip is to be produced are connected, and in the connection box (5) the phases of the bank of resistances (7) are disconnected and the phases where the voltage dip is to be produced are short-circuited in order to produce single-phase, two-phase and three-phase dips. Then, in a third step the bypass switch (9) of bank of impedances is opened in order to connect the impedances (6) and thereby isolate the grid from the voltage dip before in a fourth step the voltage dip is produced by closing the switch (14).

To conduct frequency tests, in a first step, in the connection box (23) the connection between the resistances (7) and the rectifier (22) is performed, leaving the switches (12), (13), (14) and (15) open, before continuing in a second step with the connection of the step-down transformer (21), which is in series with the rectifier (22) and in parallel with the grid (3) and the generator (2). Then, in a third step the rectifier (22) is controlled so that it consumes all the power that the generator (2) is supplying, and, at a given point, in a fourth step the switch (8) is opened to leave the generator (2) in island operation (disconnected from the grid), before ending with a fifth step in which the rectifier (22) is controlled so that it demands more/less power from the generator (2), as a result of which the frequency is increased/reduced.

An alternative simplified embodiment is contemplated in which the step-down transformer (21), the rectifier (22), the connection box (23), the battery of capacitors (20) and its connection switch (19) are removed, as are the resistances (7) and their related switches (12 and 13), with the range of tests that may be carried out also being reduced as a result.

## Claims

1. Device generating disturbances in electrical grids, **characterised in that** it comprises:
a three-phase transformer (1) having variable taps connected in series between the electrical energy generator system (2) and the grid (3), by means of two connection boxes (4,5),
a three-phase bank of impedances (6) with different taps,
a three-phase bank of resistances (7) with different taps,
single-phase vacuum switches (8) arranged in series with the bank of impedances (6) and the bank of resistances (7) for their connection separately or collectively with the transformer (1) and also in series between the generator system (2) and the grid (3),
a bypass switch (9) on the three-phase bank of impedances for the direct connection of the grid (3) with the generator system (2),
isolator switches (10) and (11) on the three-phase bank of impedances (6) for operating the impedance taps and/or resistance taps in a safe manner,
an automatic switch (12) and an isolator switch (13) on the three-phase bank of resistances (7) used to operate the resistance taps in a safe manner,
automatic connection switches (14) and (15) of the transformer (1) for operating the transformer taps in a safe manner and for conducting the different types of tests,
a coupling/decoupling circuit breaker (16) situated at the test device's outlet to the grid (3),
an auxiliary service transformer (17) and
the relevant control, measuring and communication devices (18), powered from the auxiliary service transformer (17).

2. Device generating disturbances, according to claim 1, **characterised in that** it comprises:
a step-down transformer (21) and a rectifier (22) arranged in parallel between the generator system (2) and the grid (3), and in series with the resistances (7),
a connection box (23) between the resistances (7) and the rectifier (22) and the automatic switch (12),
a battery of capacitors (20) at the input to the generator system (2), along with a connection switch (19) on said battery of capacitors (20).

3. Device generating disturbances, according to any of the preceding claims, wherein the connection box (4) connecting the transformer (1) to the generator system (2) allows the connection of one, two or three phases for carrying out single-phase, two-phase or three-phase tests, as well as to perform star and delta connections and their inverse connection.

4. Device generating disturbances, according to any of the preceding claims, wherein the connection box (5) connecting the transformer (1) to the collector system (3) allows the connection of one, two or three phases for performing single-phase, two-phase or three-phase tests, as well as to perform star and delta connections and their inverse connection.

5. Test procedure using a device generating electrical disturbances such as the one described in the preceding claims, **characterised in that** it performs voltage-surge, voltage-dip, phase-jump and zero-residual-voltage tests, by means of different combinations of the connections of the transformer (1) in the boxes (4) and (5), along with different connections of the banks of impedances (6) and resistances (7) by means of different positions in the different switches.

6. Test procedure, according to claim 5, wherein in order to carry out voltage-surge and voltage-dip tests by means of the transformer (1) connected in series between the grid (3) and the generator (2), in a first step the switches (10) and (11) or (12) and (13) are opened and earthed, depending on whether the tests are performed with pre-insertion impedances (6) or pre-insertion resistances (7) respectively, and the required resistance (7) and/or impedance (6) tap is selected. Then in a second step the switches (14) and (15) are opened and earthed so that the transformer tap can be selected and the connection boxes (4) and (5) operated in a safe manner. In a third step one, two or three phases of the connection boxes (4) and (5) are connected depending on whether the test is single-phase, two-phase or three-phase, and the transformer (1) tap in the connection box (5) is selected as required so that the required voltage may be obtained. Then in a fourth step the switches (10) and (11) or (12) and (13) are closed, and the bypass switch (9) of the bank of impedances is opened to reduce the short-circuit current running through the transformer (1). Then, to perform the test, in a fifth step the connection switches (14) and (15) of the transformer are closed before, finally, in a sixth step the corresponding phases of the switch (8) are opened depending on whether the test is single-phase, two-phase or three-phase.

7. Test procedure, according to claim 5, wherein the 30-degree phase-jump test is carried out in the same manner as the voltage-surge tests, with the exception that in this case the transformer (1) is star-delta connected.

8. Test procedure, according to claim 5, wherein phase-jump tests with a phase jump of other than 30 degrees are performed by means of the transformer (1) connected in series between the grid (3) and the generator (2), with in a first step the transformer (1) being star-delta connected so that in a second step the impedance (6) tap and/or resistance (7) tap may be selected in order to obtain the required phase-shift, followed by a third step in which the switches (10) and (11) or (12) and (13) are closed. Then in a fourth step the bypass switch (9) of the bank of impedances is opened, and finally, in order to perform the test, in a fifth step the connection switches (14) and (15) of the transformer are closed.

9. Test procedure, according to claim 5, wherein in order to produce voltage surges using the battery of capacitors (20), in a first step the impedance (6) tap required to limit the short-circuit power at the test point is selected. This allows the voltage to be raised with a smaller capacity (ohmic value) when the connection switch (19) of the battery of capacitors is connected. Then, in a second step the bypass switch (9) of the impedances is opened, and then in a third step the switch on the battery of capacitors (19) is closed.

10. Test procedure, according to claim 5, wherein in order to produce voltage dips with resistances by means of the inductive divider method, in a first step the value of the resistance (7) is selected in order to obtain the required dip depth and the impedances (6) tap necessary to limit the short-circuit current and isolate the test from the grid. Then, in a second step the connection box (5) is disconnected both from the transformer (1) and from the switch (15) and the phases in which the voltage dip is to be produced are short-circuited, followed by a third step that involves the connection in the connection box (23) between the resistances (7) and the switch (12). Then, in a fourth step the bypass switch (9) of the bank of impedances is opened in order to connect the impedances (6), before a final step in which the test is performed by closing the switch (12).

11. Test procedure, according to claim 5, wherein the zero-residual-voltage test is carried out in the same manner as in the case of voltage dips with resistances (7), but involves disconnecting the connection in the connection box (23) between the switch (12) and the bank of resistances (7) and short-circuiting the phases in which the voltage dip is to be produced.

12. Test procedure, according to claim 5, wherein the test of voltage dips of low depth and long duration may be performed by connecting in series the transformer (1) and the bank of resistances (7), and these in parallel between the grid (3) and the generator (2). This involves, in a first step, selecting the impedance (6) tap in order to limit the short-circuit current, and the resistance (7) tap and the transformer (1) tap in order to adjust the residual voltage. Then, in a second step in the connection box (4) the phases in which the dip is to be produced are connected, and in the connection box (5) the transformer (1) is connected to the branch of the resistances (7) and only the phases in which the fault is to be produced. In the connection box (23) the bank of resistances is disconnected from the switch (12) and the rectifier (fault) and the branches where the voltage dip is to be produced are short-circuited in order to produce single-phase, two-phase and three-phase dips. Then, in a third step the switches (14), (12), (13) and (15) are opened prior to a fourth step in which the bypass switch (9) of the bank of impedances is opened in order to connect the impedances (6) and thereby isolate the grid from the voltage dip, before ending with a fifth step in which the switch (14) is closed in order to produce the voltage dip.

13. Test procedure, according to claim 5, wherein the voltage-dip test may also be performed by connecting only the transformer (1) in parallel between the grid (3) and the generator (2). This involves, in a first step, selecting the impedance (6) tap in order to limit the short-circuit current, and the transformer (1) tap in order to adjust the residual voltage. Then, in a second step in the connection box (4) the phases in which the dip is to be produced are connected, and in the connection box (5) the phases of the bank of resistances (7) are disconnected and the phases where the voltage dip is to be produced are short-circuited in order to produce single-phase, two-phase and three-phase dips. Then in a third step the bypass switch (9) of bank of impedances is opened in order to connect the impedances (6) and thereby isolate the grid from the voltage dip before in a fourth step the voltage dip is produced by closing the switch (14).

14. Test procedure, according to claim 5, wherein in order to conduct the frequency test, in a first step, in the connection box (23) the connection between the resistances (7) and the rectifier (22) is produced, leaving the switches (12), (13), (14) and (15) open, before continuing in a second step with the connection of the step-down transformer (21), which is in series with the rectifier (22) and in parallel with the grid (3) and the generator (2). Then, in a third step the rectifier (22) is controlled so that it consumes all the power that the generator (2) is supplying, and, at a given point, in a fourth step the switch (8) is opened to leave the generator (2) in island operation (disconnected from the grid), before ending with a fifth step in which the rectifier (22) is controlled so that it demands more/less power from the generator (2), as a result of which the frequency is increased/decreased.
